Europäisches Patentamt

European Patent Office

Office européen des brevets

(19)

(11) Veröffentlichungsnummer : **0 117 499**
**B1**

# EUROPÄISCHE PATENTSCHRIFT

(12)

(45) Veröffentlichungstag der Patentschrift :
25.05.88

(21) Anmeldenummer : 84101708.0

(22) Anmeldetag : 18.02.84

(51) Int. Cl.⁴ : **H 03 J   7/02**

(54) Schaltungsanordnung zum Messen und Erkennen einer maximalen Ausgangsspannung.

(30) Priorität : 24.02.83 DE 3306401

(43) Veröffentlichungstag der Anmeldung :
05.09.84 Patentblatt 84/36

(45) Bekanntmachung des Hinweises auf die Patenterteilung : 25.05.88 Patentblatt 88/21

(84) Benannte Vertragsstaaten :
AT BE CH DE FR GB IT LI LU NL SE

(56) Entgegenhaltungen :
DE-A- 2 201 221
DE-A- 2 854 852
DE-A- 3 148 085
US-A- 3 495 195
US-A- 4 334 323

(73) Patentinhaber : Deutsche Thomson-Brandt GmbH
Hermann-Schwer-Strasse 3 Postfach 2060
D-7730 Villingen-Schwenningen (DE)

(72) Erfinder : Maier, Gerhard
Reutestrasse 19
D-7735 Dauchingen (DE)
Erfinder : Lange, Joachim
Freiburger Strasse 61
D-7730 Villingen-Schwenningen (DE)

## Beschreibung

Die Erfindung geht aus von einer Schaltungsanordnung zum Messen und Erkennen einer maximalen Ausgangsspannung an einem frequenzselektiven elektronischen Meßobjekt, dem aus einem Generator eine feste Meßfrequenz zugeführt wird, wobei zum Erreichen einer optimalen Abstimmung dem Meßobjekt eine schrittweise veränderbare Steuerspannung zugeleitet wird. Bei Erreichen der optimalen Abstimmung wird die Veränderung der Steuerspannung unterbrochen und damit die Steuerspannung konstant gehalten.

Eine derartige Anordnung ist sehr nützlich beim Abgleich von Hochfrequenzfilterkreisen in Nachrichtenempfangsgeräten.

Es ist z. B. eine automatische Abgleichanlage für derartige Geräte bekannt (DE-A-28 54 852), bei welcher mittels dreier Hilfsoszillatoren und diesen zugeordneten Analogspeichern unter Verwendung der PLL-Schaltung die Hochfrequenzkreise auf die gewünschte Empfangsfrequenz abgestimmt werden. Bei dieser Abstimmeinheit wird auch dabei der Tuneroszillator beim Abgleich herangezogen. Außerdem sind der Zahl der abzugleichenden Hochfrequenzkreise entsprechende Hilfsoszillatoren notwendig. Die Zahl der benötigten Hilfsoszillatoren und somit der Materialaufwand erhöht sich dann in besonderem Maße, wenn z. B. beim Abgleich eines Fernsehempfängers Band I, Band III und die Bänder IV und V abgeglichen werden sollen. Es besteht dabei die Gefahr von Mehrdeutigkeiten zwischen den Frequenzen des Tuneroszillators, der Hilfsoszillatoren und den Empfangsfrequenzen. Nachteilig für eine praktikable Realisierung der vorgeschlagenen Abstimmeinheit ist, daß die Erregerwicklungen der Hilfsoszillatoren mit den einzelnen Spulen in der Hochfrequenzkreisen unerwünschte Resonanzen und Bedämpfungen der Kreise hervorrufen können, die auch noch eine unkontrollierbare Verstimmung der Kreise verursachen, wenn die Hilfsoszillatoren nach erfolgtem Abgleich abgeschaltet sind.

Aus der DE-A-31 48 085 ist ferner ein Mehrstationsempfänger bekannt, bei dem über eine Pegelvergleichsschaltung der jeweils beste Sender ausgewählt wird.

Der vorliegenden Erfindung liegt die Aufgabe zugrunde, eine Schaltungsanordnung anzugeben, die sehr kostengünstig aufgebaut werden kann. Diese Aufgabe wird bei einer Schaltungsanordnung der eingangs beschriebenen Art durch die im Kennzeichen des Hauptanspruchs angegebenen Maßnahmen gelöst. Weitere vorteilhafte Maßnahmen zur Lösung der gestellten Aufgabe ergeben sich aus den Unteransprüchen.

Die Erfindung bringt den Vorteil, daß die Auflösung zur Erzielung eines exakten Maximumabgleichs sehr groß ist und daß der Dynamikbereich des Abgleichs wesentlich vergrößert ist, da durch die Maßnahme des Anspruchs 4 sowohl kleine als auch große Meßspannungen verarbeitet werden.

Dadurch ist es unerheblich, in welchem Spannungsbereich daß abzugleichende Maximum liegt.

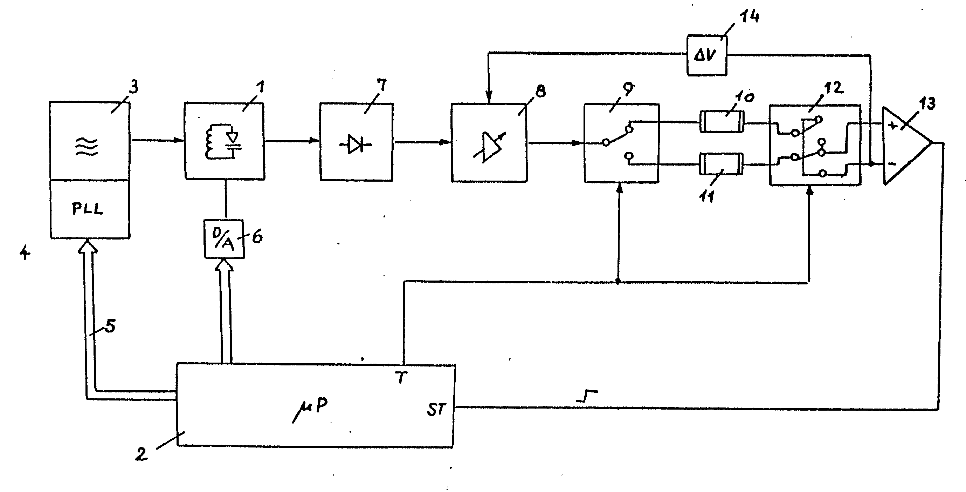

Nachstehend soll an einem Ausführungsbeispiel das Wesentliche mit Hilfe der Zeichnung näher erläutert werden.

Mit 1 ist ein Filterkreis eines HP-Empfangsgerätes bezeichnet, der auf nachfolgend beschriebene Weise mit Hilfe der Schaltung automatisch auf einen optimalen Wert abgeglichen werden soll. Zunächst wird über eine Steuereinheit 2 ein Oszillator 3 auf eine feste Frequenz eingestellt, auf die das Filter 1 optimal abgeglichen werden soll. Das Einstellen der festen Meßfrequenz geschieht z. B. durch Einstellen einer PLL-Schaltung 4 über die Datenleitung 5. Das Filter besitzt zum Abgleich eine spannungsgesteuerte Kapazitätsdiode, die aus der Steuereinheit 2 über einen Digital-Analogwandler 6 eine Abstimmspannung erhält. Nach Gleichrichtung der Meßspannung mit Hilfe des Gleichrichters 7 und nach deren Verstärkung durch den Verstärker 8 wird diese auf einen Umschalter 9 gegeben. Dieser Umschalter wird mit Hilfe eines aus der Steuereinheit 2 gelieferten Taktes T wechselweise umgeschaltet. Die Meßwerte werden dadurch an Analogspeicher 10 und 11 gelegt, die die Werte zwischenspeichern. Die Speicher sind mit je einem Eingang eines Kreuzschalters 12 verbunden, dessen Kontakte vom gleichen Takt T synchron zum Umschalter 9 geschaltet werden. Von dem Kreuzschalter 12 gelangen die Meßwerte auf einen als Differenzverstärker 13 geschalteten Stoppimpulserzeuger. Mit jedem Takt T aus der Steuereinheit 2 wird die Abstimmspannung um einen digitalen Schritt verändert. Durch das Umschalten des Kreuzschalters 12 gelangt der jeweils zuletzt gemessene Spannungswert an den gleichen Eingang des Differenzverstärkers 13. Es sei angenommen, daß bei Erreichen eines maximalen Spannungswertes am Eingang des Differenzverstärkers 13 ein positiver Impuls am Ausgang erscheinen soll. In diesem Fall muß der jeweils aktuelle Meßwert an den invertierenden Eingang des Differenzverstärkers gelegt werden. Sobald dieser aktuelle Meßwert durch das getaktete Hochschalten der Abstimmspannung am Filter 1 kleiner zu werden beginnt, entsteht am Ausgang des Differenzverstärkers 13 ein positiver Impuls, der auf einen Eingang ST der Steuereinheit 2 geschaltet wird. Dieser Impuls wird von der Steuereinheit derart verarbeitet, daß eine weitere Veränderung der Abstimmspannung unterbleibt. Der so ermittelte Wert kann als optimale Abstimmspannung abgespeichert werden. Bei mehrkreisigen Empfangsanlagen kann die Steuereinheit 2 den gleichen Einstellvorgang für das nächste Filter vornehmen, bis das gesamte Empfangsgeräte optimal abgeglichen ist.

In Abhängigkeit von dem erhaltenen Meßwert kann der Verstärkungsgrad des Gleichspannungsverstärkers 8 mit Hilfe einer Steuerstufe 14 verändert werden, so daß die beschriebene Anordnung unabhängig von der Größe der Meßspannung wird. Im Bereich des Maximums der Messung wird dadurch eine sensible Auswertung erzielt.

**Patentansprüche**

1. Schaltungsanordnung zum Messen und Erkennen einer maximalen Ausgangsspannung an einem frequenzselektiven elektronischen Meßobjekt (Filter) (1), dem aus einem Generator (3) eine feste Meßfrequenz zugeführt wird und mit einer Steuereinheit (2), welche eine schrittweise veränderbare Steuerspannung zur Abstimmung von in dem Meßobjekt (1) angeordneten Kapazitätsdioden abgibt und mit einer Gleichrichteranordnung (7) und einem Gleichspannungsverstärker (8) zur Gleichrichtung und Verstärkung der am Meßobjekt (1) abgenommenen Meßspannung, dadurch gekennzeichnet, daß ein von der Steuereinheit (2) getakteter Umschalter (9) vorgesehen ist, an dessen Eingang die gleichgerichtete und verstärkte Meßspannung geschaltet ist und daß an je einen Ausgang des Umschalters (9) ein analoger Zwischenspeicher (10, 11) zur Speicherung des am Ausgang des Umschalters (9) liegenden Spannungswertes geschaltet ist und daß die beiden Zwischenspeicher (10, 11) an je einen Eingang eines ebenfalls von der Steuereinheit (2) getakteten · Kreuzschalters (12) angelegt sind, dessen Ausgänge an eine Stoppimpulssteuerstufe (13) geschaltet sind, welche bei Erreichen eines Maximalwertes der Meßspannung einen Impuls an die Steuereinheit (2) abgibt, die eine weitere Veränderung der Abstimmspannung für das Meßobjekt (1) unterbricht.

2. Schaltungsanordnung nach Anspruch 1, dadurch gekennzeichnet, daß die Stoppimpulserzeugerstufe (13) zwei Eingänge besitzt, die mit je einem Ausgang des Kreuzschalters (12) verbunden sind.

3. Schaltungsanordnung nach Anspruch 1, dadurch gekennzeichnet, daß der Kreuzschalter (12) derart gesteuert ist, daß der jeweils diesem zugeführte letzte Meßwert aus einem der Speicher (10, 11) jeweils auf denselben Eingang der Stoppimpulserzeugerstufe (13) gelangt.

4. Schaltungsanordnung nach Anspruch 1, dadurch gekennzeichnet, daß der die Meßspannung verstärkende Gleichspannungsverstärker (8) in seiner Verstärkung in Abhängigkeit von der am Ausgang der Meßschaltung liegenden Spannung in der Weise gesteuert ist, daß die Verstärkung bei kleinen Meßspannungen groß ist und umgekehrt.

**Claims**

1. A circuit arrangement for measuring and detecting a maximum output voltage at a frequency-selective electronic test object (filter) (1) to which is fed a fixed measuring frequency from a generator (3), and comprizing a control unit (2) which emits a control voltage, changeable in steps, for tuning capacitance diodes which are incorporated in the test object (1), and comprizing also a rectifying system (7) and a direct voltage amplifier (8) for rectifying and amplifying the test voltage taken from the test object (1), characterized in that a change-over switch (9), clocked by the control unit (2), is incorporated, to the input of which the rectified and amplified test voltage is connected, and that an analogue intermediate store (10, 11) is connected to each output of the change-over switch (9) for the purpose of storing the voltage value current on the output of the change-over switch (9), and that the two intermediate stores (10, 11) are connected to respective inputs of an intermediate switch (12), which is also clocked by the control unit (2), and the outputs of which are connected to a stop pulse control stage (13), the latter sending a pulse to the control unit (2) when a maximum value of the test voltage is reached, which control unit then interrupts any further alteration of the tuning voltage for the test object (1).

2. A circuit arrangement as claimed in Claim 1, characterized in that the stop pulse generator stage (13) has two inputs, each connected to a respective output of the intermediate switch (12).

3. A circuit arrangement as claimed in Claim 1, characterized in that the intermediate switch (12) is controlled so that the last measured value which has been fed to it from one of the stores (10, 11) reaches the same input of the stop pulse generator stage (13).

4. A circuit arrangement as claimed in Claim 1, characterized in that the direct voltage amplifier (8) which amplifies the test voltage has its amplification controlled as a function of the voltage current existing at the output of the measuring circuit, so that the said amplification is great for small test voltages, and vice versa.

**Revendications**

1. Circuit pour la mesure et la détection d'une tension de sortie maximale sur un objet de mesure électronique à sélectivité de fréquence (1) (filtre), auquel est envoyée à partir d'un générateur (3) une fréquence de mesure fixe par une unité de commande (2), qui produit une tension à réglage par sauts successifs et sert à l'accord des diodes à capacité variable disposées dans l'objet de mesure (1), et avec un dispositif redresseur (7) et un amplificateur de tension continue (8) pour le redressement et l'amplification de la tension de mesure prise sur l'objet de mesure (1), caractérisé par le fait qu'un inverseur (9), synchronisé par l'unité de commande (2), est prévu, sur l'entrée duquel est envoyée la tension de mesure redressée et amplifiée, et que chaque sortie de l'inverseur (9) est reliée à une mémoire analogique temporaire (10, 11) pour la mémorisation de la valeur de tension à la sortie de l'inverseur (9), et que les deux mémoires intermédiaires (10 et 11) sont reliées respectivement à une entrée de l'inverseur synchronisé (12) également synchronisé par l'unité de commande (2), les sorties de l'inverseur étant reliées à un étage de commande à impulsions d'arrêt (13) qui émet, lorsque la valeur maximale de la tension de mesure est atteinte, une impulsion vers l'unité de commande (2), laquelle interrompt la modification de la tension d'accord pour l'objet de mesure (1).

2. Circuit selon la revendication 1, caractérisé par le fait que l'étage de génération d'impulsions d'arrêt (13) possède deux entrées, reliées respectivement à l'une des sorties de l'inverseur (12).

3. Circuit selon la revendication 1, caractérisé par le fait que l'inverseur (12) est commandé de telle sorte que, la dernière valeur de mesure lui étant à chaque fois envoyée de l'une des mémoires (10, 11) parvient à la même entrée de l'étage de génération d'impulsions d'arrêt (13).

4. Circuit selon la revendication 1, caractérisé par le fait que l'amplificateur de tension continue (8), qui amplifie la tension de mesure, est commandé dans son amplification en fonction de la tension présente à la sortie du circuit de mesure de telle sorte que l'amplification est grande pour des valeurs de tension faibles, et inversement.